# EUROPEAN PATENT SPECIFICATION

(11) **EP 1 736 566 B1**
(45) Date of publication and mention of the grant of the patent: **14.07.2010**
(21) Application number: 05730221.8
(22) Date of filing: 23.03.2005
(51) Int. Cl.: C23C 14/34, B32B 15/08

(54) **METHOD OF APPLYING COATINGS WITH A METALLIC OR CERAMIC FINISH**
VERFAHREN ZUM AUFBRINGEN VON BECHICHTUNGEN MIT METALL- ODER KERAMIKFINISH
PROCEDE D'APPLICATION DE REVETEMENTS A FINITION METALLIQUE OU CERAMIQUE

(30) Priority: 26.03.2004 ES 200400753
(43) Date of publication of application: 27.12.2006
(73) Proprietor: SIDA S.A., 08014 Barcelona (ES)
(72) Inventor: BENELMEKKI ERRETBY, Maria Centre d'Empreses de Noves Tecnologies, E-08290 Cerdanyola del Valles (ES); RIERA GINER, Montse Centre d'Empreses de Noves Tecnologies, E-08290 Cerdanyola del Valles (ES)
(74) Representative: Carpintero Lopez, Francisco
(86) International application number: PCT/ES2005/000157
(87) International publication number: WO 2005/093121

(56) References cited:
- EP-A1- 0 351 533
- US-A- 5 006 212

## Description

### FIELD OF THE INVENTION

The present invention relates to the field of coatings. Specifically, it relates to a method of applying coatings with a metallic or ceramic finish to thermoplastic, metallic and metal alloy articles so that these present a decorative and protective layer. These coatings can be metallic, such as a metal or alloy, or ceramic. The coating method comprises applying a polymeric layer (from dispersions of polymers in water or organic solvents), curing it and subsequently applying a metallic or ceramic single-layer coating by physical vapor deposition (PVD) techniques. In this way a decorative layer is obtained, shiny or matte as desired, on said articles, as well as improving their surface properties regarding chemical corrosion (oxidation, etc.) and mechanical stresses (mechanical scraping, etc.). In addition, in the specific case of a chroming method it ensures at all times that there is no hexavalent or trivalent chromium in the coating process or in the final product. Furthermore, the use of aqueous polymeric dispersions has the advantage of providing an entirely clean and environmentally friendly product.

### BACKGROUND OF THE INVENTION

Currently, coatings applied by electrolytic baths have numerous technical and environmental drawbacks. Control systems required by electrolytic bath processes are very strict and the processes are very complex, even more so with non-conducting substrates.

In the case of chrome plating, chrome coatings applied by electrolytic baths are used as protective layers against corrosion and as a decorative finish. In general, these coatings are made in chemical baths formulated with hexavalent chromium, a product catalogued as carcinogenic.

Recently, the industry has begun an evolution towards trivalent chromium as an acceptable alternative from an environmental protection point of view. Currently this alternative presents limitations such as a) low resistance to corrosion of the coating; b) poor quality finishes; c) formation of hexavalent chromium in the anodic oxidation process..

In addition, in conventional methods of coating by electrolytic bath plastics are non-conducting, so that they must be subjected to complex priming processes to allow them to receive the technical coatings that confer them their properties. This priming is complex and involves the use of highly toxic and hard to control products.

To obtain an article with an electrolytic chromium finish several layers must be applied to obtain the desired color and corrosion resistance. By way of example, for a correct deposition of chromium and the desired color and shine, the article (whether thermoplastic, metallic or metal alloy) must previously receive successive layers of semi-shiny and shiny nickel. In addition, depending on the articles to be treated, a copper adherence promoting layer is required. Introducing the intermediate metallic layers increases the corrosion possibilities of the part with a minimum fault in the final chromium layer.

On another hand, the use of said baths requires specialized equipment, as they are delicate and require separate control equipment for each vat, as each vat has different characteristics of temperature, filtering, stirring and amperage.

Recently, improvements have been made in the trivalent chromium plating process, such as in the color, appearance, process control, etc., but it is not yet possible to obtain a deposit with the same surface characteristics as that provided by hexavalent chromium.

Electrodeposition with trivalent chromium has the problem of a poor stability of the baths due to the formation of hexavalent chromium due to anodic oxidation. In this sense, trivalent chromium baths have been proposed as that described in US Patent 5,560,815 which uses an adapted electrode, considerably reducing the formation of hexavalent chromium. However, it is not yet possible to eliminate this product completely.

Another way to provide a decorative metallic and corrosion protective finish to said articles invoives applying a coating by vapor deposition (PVD) techniques with a prior application of electrolytic coatings that serve to mask the faults of the substrate surface. The following patents describe the application of coatings by PVD techniques to articles previously coated by electrodeposition: US 5814415; US 5667904; US 5626972; US 5948548; US 6221231; US 6106958; US 6245435; US 5759677; EP928343.

Another way to obtain a metallic (chrome) finish (US 2002/0170460) is the use of an organic layer to level the surface of the layer on which is subsequently applied a multi-layer of Cr-Ni to improve adherence, followed by the final chromium layer. Both the Cr-Ni and chromium layers are applied by PVD. Finally, an organic layer is applied to protect the PVD multi-layer.

In said process the use of electrolytic chromium is eliminated, but it requires applying two organic layers, one to level the surface of the article and another to protect the Cr-Ni/Cr multi-layer against corrosion due to the presence of Ni. The use of multi-layer metallic coatings including Ni increases the likelihood of corrosion of the articles and complicates the coating process of the various articles, excluding arc PVD as a coating technique due to the magnetic properties of nickel.

In addition, it is possible to use a polymeric layer instead of the electrolytic metallic layers and to deposit the subsequent chromium coating by PVD techniques. In the European patent application EP 0351533 A1 a method is disclosed wherein a dielectric substrate such as a ceramic substrate with a polyimide film onto is coated with a chromium layer and a copper layer and optionally with a further chromium layer. Also, in the US patent 5,006,212 a method is described wherein a ceramic substrate is coated with a thick layer of an organic polymer that is in tum coated with a thin layer of silicon dioxide onto which is deposited a think layer of chrome. This is the case in the coating described in US Patent 6,652,988 B2 (2003), which relates to an article with a decorative coating resistant to abrasion, wear and corrosion, composed of a polymeric layer resulting of the reaction of an epoxy/urethane resin and polyamide or an epoxy/urethane resin in organic solvents, and a decorative coating formed by at least one layer obtained by vapor deposition. This layer consists of a chromium, chromium compound, refractory metal compound or refractory metal alloy compound layer.

Said coating prevents the need for electrolytic layers, but requires the use of urethane resins containing isocyanates, which present health hazards as in the application of these resins drops of un-reacted isocyanate may be inhaled. In addition to these serious drawbacks, the method is limited by the type of substrates to be coated, as the curing temperature of this epoxy/urethane based resins are relatively high, preventing their use on articles made of materials with a low melting point, particularly thermoplastics.

Therefore, although the state of the art includes several methods for applying decorative and protective coatings on thermoplastic, metallic or metal alloy articles, the need remains to develop alternative methods that, in addition to providing a coating with a metallic or ceramic finish resistant to chemical and mechanical corrosion, ensure the absence in the process and in the coated article of hazardous compounds such as isocyanates, or in the case of chrome plating, hexavalent or trivalent chromium, which in addition allow to work with a wider range of substrates without temperature limits.

The coating method of the present invention provides coatings with a metallic or ceramic finish preventing the formation of isocyanates and allowing, in addition, to coat articles made of materials with a low melting point. In addition, when using photosensitive resins, as UV curing is instantaneous it allows shorter processes and therefore more economical processes on an industrial level, preventing possible chemical attack on delicate substrates.

Similarly, in the specific case of coatings with an electrolytic chromium finish, metallic chromium is used to start with and is deposited as metallic chromium, so that hexavalent or trivalent chromium are not formed at any time in the process.

### OBJECT OF THE INVENTION

The object of the present invention is therefore to provide a method of applying a coating with a metallic or ceramic finish to all or part of thermoplastic, metallic or metal alloy articles. Said coating confers the articles a metallic or ceramic appearance, as desired, as well as resistance against chemical corrosion, external stresses owing to climate changes and mechanical abrasion caused by daily use. In addition, said coating reduces the risk of corrosion due to the absence of the prior nickel layers and ensures the absence, both in the coating and in the process for obtaining said coating, of isocyanates and hexavalent and trivalent chromium, when applicable. Lastly, said coating can be applied on a wide range of thermoplastic, metallic or metal alloy articles.

### DESCRIPTION OF THE INVENTION

The present invention provides a method for applying a coating with a metallic or ceramic finish to all or part of the surface of a thermoplastic, metallic or metal alloy material, comprising the following steps:
(a) preparing the thermoplastic, metallic or metal alloy article;
(b) applying on said article a polymeric layer based on aqueous dispersions of resins that are free of volatile organic components or dispersions in organic solvents of resins that are free of urethane;
(c) curing said polymeric layer; and
(d) depositing a single layer of a metallic or ceramic material on the article coated with the cured polymeric layer;
in which the curing of said polymeric layer of step (c) is performed at a temperature between 30 and 80 °C in the case of thermal polymeric layers, or by ultraviolet radiation in the case of photosensitive polymeric layers.

In the context of the invention, the term "coating with metallic or ceramic finish" refers to a coating on an article or object whose surface has an attractive and aesthetic metallic or ceramic appearance, whether shiny or matte, which is conserved throughout its time of use.

Similarly, in the context of the invention the term "thermoplastic article" refers to an article made of a thermoplastic polymeric material whose maximum working temperature, beyond which it the allowable deformation is exceeded, is between 50 and 150 °C. Thus, for example, the maximum working temperatures of some thermoplastic articles used in the invention are:
- Acrylonitryl-butadiene-styrene (ABS) = 85-100 °C
- Polycarbonate (PC) = 130-140 °C
- Polypropylene (PP)= 90-120 °C
- Polyamide (PA)= 80-140 °C
- Polyvinyl chloride (PVC) = 50-75 °C
- ABS-PC type copolymers = 105-120 °C

These temperatures are approximate, as they depend on how the corresponding plastic is produced.

In a particular embodiment of the method of the invention, the metallic material is a metal or a metal alloy, preferably chromium, ruthenium, alloy of silver and rhodium or alloy of palladium and nickel.

In another particular embodiment, the ceramic material is a nitride or a carbonitride, preferably chromium nitride or zirconium carbonitride.

Similarly, in the context of the invention the term "polymeric layer" relates to a resin layer with a high ability to fill and level rough surfaces, as well as a stable behavior at low pressures. This layer acts as a primer, improving the adherence of the metallic layer and the leveling function, covering the polishing faults of the substrate to provide a mirror-like shine in the final appearance of the article.

More specifically, said layer is a polymeric layer based on aqueous dispersions of resins free of volatile components (Zero VOC's) or one based on dispersions in organic solvents of urethane-free resins. Both types of polymeric layers may be cured at a temperature ranging from 30 °C to 80 °C, or by ultraviolet radiation for a time from 1 second to 10 minutes, depending on the substrate used, as previously described.

The polymeric layer acts as a leveling layer, covering the polishing faults of the substrate. Its thickness is the minimum thickness required to fulfill said leveling function. Likewise, the polymeric layer promotes the adherence of the metallic layer and prevents possible degassing processes of the substrate in vacuum conditions.

In a particular embodiment of the method of the invention, the thickness of the polymeric layer applied to all or part of the surface of the thermoplastic, metallic or metal alloy article is between 1 and 20 µm preferably between 5 and 15 µm.

In a preferred embodiment of the method of the invention, the curing of step (c) is performed by drying at ambient temperature for a period ranging from 8 to 24 h.

In another preferred embodiment of the method of the invention, the curing of step (c) is performed by drying at ambient temperature for a time under 15 min and a subsequent heating in an oven at a temperature of 50-70 °C for 20-95 min.

In another preferred embodiment of the invention, the curing of step (c) is performed by ultraviolet radiation for a time under 10 min.

In a particular embodiment of the method of the invention, the step (d) involving depositing a single layer of a metallic or ceramic material on the article which has been previously coated with the cured polymeric layer comprises the following steps:
(i) exposure to a vacuum of the article coated with the cured polymeric layer; and
(ii) Depositing a single layer of a metallic or ceramic material, by a vapor deposition technique on said article coated with the cured polymeric layer and exposed to a vacuum.

In the sense used in this description, the term "vapor deposition technique" refers to any known vapor deposition technique, such as a physical vapor deposition (PVD). The techniques are based on the formation of a vapor of the material to be deposited, so that the vapor condenses on the surface of the substrate to form a thin layer. Generally, the process must be performed in a vacuum or in a controlled atmosphere in order to prevent the interaction of the vapor with the atmospheric air. In PVD techniques a solid material is converted to a vapor by thermal or cathode arc evaporation, or by ion bombardment (sputtering). The material in vapor form condenses on the surface of the substrate as a thin layer.

More specifically, the cathode arc PVD technique consists of evaporating the material to be deposited by creating an electric arc on the target surface (the material to be evaporated). The material "evaporates" in the form of ions which are deposited on the substrate. The PVD technique by sputtering consists of bombarding the target surface (the material to be deposited) with Argon Ions, removing atoms that collide with the Ar ions and electrons to form a plasma that is deposited on the substrate to be coated.

In a specific embodiment of the present invention, said vapor deposition technique is a physical vapor deposition (PVD) technique, preferably cathode arc or sputtering PVD at a temperature under the maximum working temperature of the substrate.

The curing of the polymeric layer at temperatures from 30°C to 80°C or by ultraviolet radiation, depending on the substrate used, allows coating a greater range of substrates without temperature limits. Said curing also implies other additional advantages:
- The curing allows a complete degassing of the polymeric layer and the substrate, which allows obtaining a very stable working vacuum in the PVD coating chamber, a very good adherence of the PVD layer and an excellent resistance to humidity;
- As they are cured parts, the PVD coating can be performed at ambient temperature without having to preheat the parts, which allows shorter processes and therefore results in a lower cost of the final products;
- Curing by ultraviolet radiation is a process that lasts from 1 second to 10 minutes, which allows very short and quick processes that implies economical industrial processes. In addition, curing by UV radiation is a very fast process and thus allows to treat very delicate samples, preventing a possible attack to the parts by the product itself;
- The aqueous polymeric dispersions used to prepare the intermediate polymeric layer have the advantage of being completely clean and environmentally friendly products.

In another particular embodiment of the method of the present invention, step (a) for preparation of the article comprises the following steps:
(i) cleaning the article; and
(ii) drying the cleaned article.

More specifically, cleaning is performed with organic solvents to eliminate oxides and particles from the surface with a minimal attack, preferably by ethanol baths in an ultrasound washer for a time between 5 and 20 minutes.

In short, the articles to be coated are subjected to a cleaning process by organic solvents as described above. Then the polymeric layer is applied on said articles by a conventional deposition technique, such as immersion, spraying by automatic air guns, airless spraying, electro-coating, brushing, etc. After the polymeric layer is applied, in the case of a heat curing polymeric layer the diluent is evaporated and the resin is cured at an appropriate temperature, from 30 to 80 °C. In the case of a photosensitive polymeric layer, it is cured with ultraviolet radiation. Then the articles coated with the cured polymeric layer are subjected to a vacuum and a nanometric layer of the desired metallic or ceramic material is deposited on them by a vapor deposition technique, as described above.

In a particular embodiment of the method of the invention, the single layer of a metallic or ceramic material obtained after step (d) has a thickness between 10 and 600 nm, preferably between 10 and 300 nm.

In a preferred embodiment of the method of the invention, the ruthenium single layer obtained after step (d) has a thickness between 20 and 500 nm, preferably between 20 and 200 nm.

Lastly, in another specific embodiment of the method of the invention the coating with an electrolytic chromium finish obtained does not contain hexavalent or trivalent chromium.

Said metallic chromium layer, as those of ruthenium, silver-rhodium or zirconium carbonitride, for example, provides a decorative appearance to the article as well as resistance against chemical corrosion and mechanical stresses.

In general, the coating based on a metal or metal alloy applied on the aforementioned articles is a coating that allows giving said articles a metallic appearance with a mirror-like shine.

### EXAMPLE 1

### Method of coating an ABS article with a polymeric layer and a chromium single layer.

Firstly, the ABS articles are subjected to cleaning by baths in a non-chlorinated organic solvent, such as ethanol, in ultrasound washers.

Then a polymeric layer is applied on the pre-treated ABS articles by spraying with a compressed air gun. The resin is then cured in an oven at a temperature between 50 and 70 °C for 20-120 min.

Next a chromium single layer is deposited on the surface of the articles coated with the cured polymeric layer by cathode-arc vapor deposition technique (PVD). To do so, the articles are first subjected to a 2.5x10⁻³ Pa (2.5 x 10⁻⁵ mbar) vacuum. Then the layer is deposited evaporating the cathode material made of chromium. The working pressure is about 2.3 x 10⁻¹ Pa (2.3 x 10⁻³ mbar); the voltage applied to the targets in the deposition process is 60 A; the rotation speed of the substrate is maintained constant during the coating process, with a deposit time under 5 min. In this way a Cr coating is obtained on the ABS parts previously coated with the thermo-hardened resin with a thickness of between 10 and 300 nm.

To show the excellent adherence of the coating obtained in this way, as well as the outstanding protection against chemical corrosion of the articles coated by the above-described method, tests have been conducted according to the standard guide D6577-00a for industrial protective coating tests. The tests worth emphasizing in the present example are the following:
A) Adherence test as per standard ASTM D3359-02 relating to the measure of adherence by an adhesive tape. This test consists of applying an adhesive tape on the surface of the part, with a subsequent microscopic examination of the area of the part tested. The layer appears unaffected, keeping a smooth and shiny surface.
B) Resistance to saline chamber test (ASTM B-117).
   After subjecting the coated parts to a saline atmosphere of 5% sodium chloride at a temperature of 35 °C, the parts are visually inspected and then subjected to the adherence test. The layer appears unaffected.
C) Resistance to humidity test (ASTM D2247).
   In this test the coated articles have been submerged in water at 38 °C. Neither the chromium layer nor the polymeric layer was affected.

### EXAMPLE 2

### Method of coating an ABS article with a polymeric layer and a ruthenium single layer.

Firstly, the ABS articles are subjected to cleaning by baths in a non-chlorinated organic solvent, such as ethanol, in ultrasound washers.

Then a polymeric layer is applied on the pre-treated ABS articles by spraying with a compressed air gun. The resin is then cured in an oven at a temperature between 50 and 70 °C for 20-120 min.

Next a ruthenium single layer is deposited on the surface of the articles coated with the cured polymeric layer by sputtering vapor deposition technique (PVD). To do so, the articles are first subjected to a 2.5 x 10⁻³ Pa (2.5 x 10⁻⁵ mbar) vacuum. Then the layer is deposited stripping the material of the ruthenium target. The working pressure is about 7 x 10⁻¹ Pa (7 x 10⁻³ mbar). The bias voltage applied during the deposition process is 100 V; the rotation speed of the substrate is maintained constant during the coating process, with a deposit time under 5 min. The sputtering power is 0.8 kW. In this way a ruthenium coating is obtained on the ABS parts previously coated with the thermo-hardened resin with a thickness of between 20 and 200 nm.

To show the excellent adherence of the coating obtained in this way, as well as the outstanding protection against chemical corrosion of the articles coated by the above-described method, tests have been conducted according to the standard guide D6577-00a for industrial protective coating tests. The tests worth emphasizing in the present example are the following:
A) Adherence test as per standard ASTM D3359-02 relating to the measure of adherence by an adhesive tape. This test consists of applying an adhesive tape on the surface of the part, with a
   subsequent microscopic examination of the area of the part tested. The layer appears unaffected, keeping a smooth and shiny surface.
B) Resistance to saline chamber test (ASTM B-117).
   After subjecting the coated parts to a saline atmosphere of 5% sodium chloride at a temperature of 35 °C, the parts are visually inspected and then subjected to the adherence test. The layer appears unaffected.
C) Resistance to humidity test (ASTM D2247).
   In this test the coated articles have been submerged in water at 38 °C. Neither the ruthenium layer nor the polymeric layer was affected.
D) Heat cycle test:
   The test consists of exposing the coated part to hot air at 80°C for 30 min and then cooling it to ambient temperature. Then the part is cooled with air to -30 °C for 30 min, subsequently heating to reach the ambient temperature. Neither the ruthenium layer, the polymeric layer nor the adherence of the two layers to the ABS substrate was affected.

Although reference has been made to a particular embodiment of the invention, it should be obvious for the skilled person in the art that the method described is liable to numerous variations and modifications, and that all the details given may be replaced by other technically equivalent details without departing from the scope of protection defined by the accompanying claims.

## Claims

1. Method of applying a coating with a metallic or ceramic finish to all or part of the surface of a thermoplastic, metallic or metal alloy article, comprising the following steps:
(a) preparing the thermoplastic, metallic or metal alloy article;
(b) applying on said article a polymeric layer based on aqueous dispersions of resins that are free of volatile organic components or dispersions in organic solvents of resins that are free of urethane;
(c) curing said polymeric layer; and
(d) depositing a single layer of a metallic or ceramic material on the article coated with the cured polymeric layer;
**characterized in that** the curing of said polymeric layer of step (c) is performed at a temperature between 30 and 80 °C in the case of thermal polymeric layers, or by ultraviolet radiation in the case of photosensitive polymeric layers.

2. Method according to claim 1, **characterized in that** the metallic material is a metal or a metal alloy, preferably chromium, ruthenium, silver and rhodium alloy or palladium and nickel alloy.

3. Method according to claim 1, **characterized in that** the ceramic material is a nitride or a carbonitride, preferably chromium nitride or zirconium carbonitride.

4. Method according to claim 1, **characterized in that** the curing of step (c) is performed by drying at ambient temperature for a time between 8 and 24 hours.

5. Method according to claim 1, **characterized in that** the curing of step (c) is performed by drying at ambient temperature for a time under 15 minutes, followed by heating in an oven at a temperature of 50-70 °C for 20-95 min.

6. Method according to claim 1, **characterized in that** curing of step (c) is performed by ultraviolet radiation for a time under 10 min.

7. Method according to claim 1, **characterized in that** step (d) comprises the following steps:
(i) exposing to a vacuum the article coated with the cured polymeric layer; and
(ii) depositing a single layer of a metallic or ceramic material by a vapor deposition technique on said article coated with the cured polymeric layer and exposed to a vacuum.

8. Method according to claim 7, **characterized in that** the vapor deposition technique is physical vapor deposition (PVD) technique, preferably cathode arc PVD or sputtering PVD.

9. Method according to claim 1, **characterized in that** step (a) for preparing the article comprises the following steps:
(i) cleaning the article; and
(ii) drying the cleaned article.

10. Method according to claim 9, **characterized in that** the cleaning is performed by ethanol baths in an ultrasound washer for a time between 5 and 20 minutes.

11. Method according to claim 1, **characterized in that** the single layer of metallic or ceramic material obtained after step (d) has a thickness between 10 and 600 nm, preferably between 10 and 300 nm.

12. Method according to claim 11 **characterized in that** the metallic single layer obtained after step (d) is a layer of ruthenium that has a thickness between 20 and 500 nm, preferably between 20 and 200 nm.

13. Method according to claim 1, **characterized in that** the metallic single layer obtained after step (d) is a layer of chromium that has a finish of electolytic chromium and does not contain hexavalent or trivalent chromium.

## Patentansprüche

1. Verfahren zum Aufbringen einer Beschichtung mit einem metallischen oder keramischen Finish auf die Gesamtheit oder einen Teil der Oberfläche eines thermoplastischen, metallischen oder aus einer Metall-Legierung bestehenden Gegenstands, mit den folgenden Schritten:
(a) Vorbereiten des thermoplastischen, metallischen oder aus einer Metall-Legierung bestehenden Gegenstands;
(b) Aufbringen, auf den genannten Gegenstand, einer Polymerschicht, basierend auf wässrigen Dispersionen von Harzen, die frei von flüchtigen organischen Bestandteilen sind, oder Dispersionen in organischen Lösungsmitteln von Harzen, die frei von Urethan sind;
(c) Aushärten der genannten Polymerschicht; und
(d) Ablagern einer einzelnen Schicht aus einem metallischen oder keramischen Material auf dem Gegenstand, der mit der ausgehärteten Polymerschicht beschichtet ist;
**dadurch gekennzeichnet, dass** das Aushärten der genannten Polymerschicht in Schritt (c) bei einer Temperatur zwischen 30 und 80°C im Falle von thermischen Polymerschichten oder durch ultraviolette Bestrahlung im Falle von photosensitiven Polymerschichten ausgeführt wird.

2. Verfahren nach Anspruch 1, **dadurch gekennzeichnet, dass** das metallische Material ein Metall oder eine Metall-Legierung ist, vorzugsweise Chrom, Ruthenium, Silber und Rhodiumlegierung oder Palladium und Nickellegierung.

3. Verfahren nach Anspruch 1, **dadurch gekennzeichnet, dass** das keramische Material ein Nitrid oder ein Karbonitrid ist, vorzugsweise Chromnitrid oder Zirkon-Karbonitrid.

4. Verfahren nach Anspruch 1, **dadurch gekennzeichnet, dass** das Aushärten in Schritt (c) durch Trocknen bei Umgebungstemperatur während einer Zeitdauer zwischen 8 und 24 Stunden ausgeführt wird.

5. Verfahren nach Anspruch 1, **dadurch gekennzeichnet, dass** das Aushärten in Schritt (c) durch Trocknen bei Umgebungstemperatur während einer Zeitdauer unter 15 Minuten, gefolgt durch Erhitzen in einem Ofen auf eine Temperatur zwischen 50 und 70°C während 20 und 95 Minuten ausgeführt wird.

6. Verfahren nach Anspruch 1, **dadurch gekennzeichnet, dass** das Aushärten in Schritt (c) durch Ultraviolett-Bestrahlung während einer Zeitdauer unter 10 Minuten ausgeführt wird.

7. Verfahren nach Anspruch 1, **dadurch gekennzeichnet, dass** Schritt (d) die folgenden Schritte umfasst:
(i) der mit der ausgehärteten Polymerschicht beschichtete Gegenstand wird einem Vakuum ausgesetzt; und
(ii) eine einzelne Schicht eines metallischen oder keramischen Materials wird durch eine Dampfniederschlagstechnik auf dem genannten Artikel, der mit der ausgehärteten Polymerschicht beschichtet und einem Vakuum ausgesetzt ist, abgelagert.

8. Verfahren nach Anspruch 7, **dadurch gekennzeichnet, dass** die Dampfablagerungstechnik eine physikalische Dampfablagerungstechnik (PVD) ist, vorzugsweise Kathodenstrahl-PVD oder Sputter-PVD.

9. Verfahren nach Anspruch 1, **dadurch gekennzeichnet, dass** Schritt (a) zum Vorbereiten des Gegenstands die folgenden Schritte umfasst:
(i) Reinigen des Gegenstands; und
(ii) Trocknen des gereinigten Gegenstands.

10. Verfahren nach Anspruch 9, **dadurch gekennzeichnet, dass** das Reinigen durch Ethanolbäder in einem Ultraschall-Reinigungsgerät während einer Zeitdauer zwischen 5 und 20 Minuten ausgeführt wird.

11. Verfahren nach Anspruch 1, **dadurch gekennzeichnet, dass** die einzelne Schicht aus einem metallischen oder keramischen Material, die nach Schritt (d) erhalten wird, eine Dicke zwischen 10 und 600 nm, vorzugsweise zwischen 10 und 300 nm aufweist.

12. Verfahren nach Anspruch 1, **dadurch gekennzeichnet, dass** die metallische einzelne Schicht, die nach Schritt (d) erhalten wird, eine Schicht aus Ruthenium ist, die eine Dicke zwischen 20 und 500 nm, vorzugsweise zwischen 20 und 200 nm aufweist.

13. Verfahren nach Anspruch 1, **dadurch gekennzeichnet, dass** die metallische einzelne Schicht, die nach Schritt (d) erhalten wird, eine Schicht aus Chrom ist, die ein Finish aus elektrolytischem Chrom aufweist und weder hexavalentes noch trivalentes Chrom enthält.

## Revendications

1. Procédé d'application d'un revêtement présentant un aspect de fini métallique ou céramique pour une partie ou la totalité de la surface d'un article formé d'un alliage métallique, d'un métal ou d'un matériau thermoplastique, comprenant les étapes suivantes:
(a) préparation d'un article formé d'un alliage métallique, d'un métal ou d'un matériau thermoplastique;
(b) application sur ledit article d'une couche polymère à base de dispersions aqueuses de résines exemptes de constituants organiques volatils ou de dispersions dans des solvants organiques de résines exemptes d'uréthane;
(c) thermodurcissage de ladite couche polymère; et
(d) dépôt d'une couche unique d'un matériau métallique ou céramique sur l'article revêtu de la couche polymère thermodurcie;
**caractérisé en ce que** le thermodurcissage de ladite couche polymère de l'étape (c) est effectué à une température entre 30 et 80°C dans le cas de couches polymères thermique ou par un rayonnement ultraviolet dans le cas de couches polymères photosensibles.

2. Un procédé selon la revendication 1, **caractérisé en ce que** le matériau métallique est un métal ou un alliage métallique, de préférence consistant en chrome, ruthénium, alliage d'argent et de rhodium, alliage de palladium et de nickel.

3. Un procédé selon la revendication 1, **caractérisé en ce que** le matériau céramique est un nitrure ou un carbonitrure, de préférence du nitrure dechrome ou du carbonitrure de zirconium.

4. Un procédé selon la revendication 1, **caractérisé en ce que** le thermodurcissage de l'étape (c) est effectué by séchage à température ambiante pendant une durée comprise entre 8 et 24 heures.

5. Un procédé selon la revendication 1, **caractérisé en ce que** le thermodurcissage de l'étape (c) est effectué par séchage à température ambiante pendant une durée inférieure à 15 minutes, suivi d'un chauffage dans un four à une température de 50 à 70 °C pendant 20 à 95 min.

6. Un procédé selon la revendication 1, **caractérisé en ce que** le thermodurcissage de l'étape (c) est effectué par des radiations ultraviolettes pendant une durée inférieure à 10 min.

7. Un procédé selon la revendication 1, **caractérisé en ce que** l'étape (d) comprend les étapes suivantes:
(i) exposition au vide de l'article revêtu de la couche du polymère thermodurcie; et
(ii) dépôt sur ledit article, revêtu de la couche de polymère thermodurcie et ayant été exposé au vide, d'une couche unique d'un matériau métallique ou céramique par la technique de métallisation sous vide.

8. Un procédé selon la revendication 7, **caractérisé en ce que** la technique de métallisation sous vide est une technique de métallisation sous vide physique (PVD), de préférence de PVD par arc cathodique ou par pulvérisation.

9. Un procédé selon la revendication 1, **caractérisé en ce que** l'étape (a) de préparation de l'article comprend les étapes suivantes:
(i) nettoyage de l'article; et
(ii) séchage de l'article ainsi nettoyé.

10. Un procédé selon la revendication 9, **caractérisé en ce que** le nettoyage est effectué par action de bains dans l'éthanol dans un lavoir à ultrasons pendant une durée comprise entre 5 et 20 minutes.

11. Un procédé selon la revendication 1, **caractérisé en ce que** la couche unique de matériau métallique ou céramique résultant de l'étape (d) présente une épaisseur comprise entre 10 et 600 nm, de préférence entre 10 et 300 nm.

12. Un procédé selon la revendication 11 **caractérisé en ce que** la couche métallique unique résultant de l'étape d) est une couche de ruthénium dont l'épaisseur est comprise entre 20 et 500 nm, de préférence entre 20 et 200 nm.

13. Un procédé selon la revendication 1, **caractérisé en ce que** la couche métallique unique résultant de l'étape d) est une couche de chrome qui présente le fini d'un chrome électrolytique et ne contient pas de chrome hexavalent ou trivalent.
